# EUROPEAN PATENT APPLICATION

(11) **EP 4 501 477 A1**
(43) Date of publication of application: **05.02.2025**
(21) Application number: 23778827.8
(22) Date of filing: 01.02.2023
(51) Int. Cl.: B09B 3/40, B09B 101/15, H01L 31/042

(54) **SOLAR CELL MODULE RECYCLING SYSTEM AND SOLAR CELL MODULE RECYCLING METHOD**

(30) Priority: 31.03.2022 JP 2022059581; 07.11.2022 JP 2022178140
(71) Applicant: TOKUYAMA CORPORATION, Yamaguchi 745-8648 (JP)
(72) Inventor: YAMASHITA, Takeharu, Shunan-shi, Yamaguchi 745-8648 (JP); INOUE, Daisuke, Shunan-shi, Yamaguchi 745-8648 (JP)
(74) Representative: Dehns
(86) International application number: PCT/JP2023/003222
(87) International publication number: WO 2023/188791

(57) **Abstract**

Provided are a solar cell module recycling system and a solar cell module recycling method capable of collecting valuable materials and collecting a collection tool efficiently by one processing to reuse the collection tool.

A solar cell module recycling system includes a thermal decomposition furnace configured to thermally decompose a used solar cell module mounted on a collection tool; a module collection conveyor configured to collect the thermally decomposed solar cell module thermally decomposed in the thermal decomposition furnace together with the collection tool; a glass collection conveyor configured to collect plate glass included in the thermally decomposed solar cell module transferred to the module collection conveyor; a valuable material collection unit configured to collect valuable materials other than the plate glass, the valuable materials being included in the thermally decomposed solar cell module; and a tool collection unit configured to collect the collection tool remaining on the module collection conveyor after the plate glass and the valuable materials are collected.

## Description

### Technical Field

The present invention relates to a solar cell module recycling system and a solar cell module recycling method in which glass and valuable materials are collected from a thermally decomposed used solar cell module while being placed on a collection tool, and the collection tool is collected to be reused.

### Background Art

Toward the realization of a low-carbon society, acceleration of CO₂ reduction by utilizing renewable energy such as solar power generation is about to progress. While introduction of the solar power generation has progressed significantly, problems of recycling in disposal of solar cell modules have been pointed out.

The structure of a general solar cell module is formed of three layers including plate glass provided on the front surface of the solar cell module, a sealing resin layer provided inside the solar cell module, and a back sheet provided on the back surface of the solar cell module. In the sealing resin layer, a ribbon wire connecting cells to each other is wired. The sealing resin is required to have properties such as transparency, flexibility, adhesiveness, tensile strength, and weather resistance, and an ethylenevinyl acetate copolymer (hereinafter abbreviated as "EVA") is generally used as the sealing resin, so that the sealing resin serves to bond the plate glass, the cells, and the back sheet to each other by heating and pressurizing.

There has been proposed a technique for recycling a solar cell module, in which the solar cell module is heated by a furnace such as an electric furnace under an oxidizing atmosphere, the EVA is thermally decomposed to remove a sealing material, and a cell section is separated from a glass substrate.

The present applicant has also proposed a processing method of collecting valuable materials from a solar cell module, in which the solar cell module is placed on a porous molded body made of a heat-resistant material supporting a transition metal oxide as a catalyst with the back sheet surface facing downward, the solar cell module is heated in a heating furnace under an oxidizing atmosphere having an oxygen concentration of 15% or more to melt a resin component, and then the resin component is combusted (refer to Patent Literature 1).

### Citation List

### Patent Literature

Patent Literature 1: WO 2020/031661 A

### Summary of Invention

### Technical Problem

However, even if the above-described processing method is realized, it is necessary to cool plate glass at a high temperature and remove the plate glass when collecting the plate glass, that is one of the valuable materials, from a thermally decomposed solar cell module, and since cells and a ribbon, that are other valuable materials, are in a scattered state, it takes much time and effort to collect the plate glass, the cells, and the ribbon at once.

In addition, to continuously repeat a cycle of thermally decomposing the solar cell module to collect the plate glass and the other valuable materials, it is convenient to perform the above-described cycle while the solar cell module is placed on a collection tool such as a net, but since it is necessary to remove the plate glass and the other valuable materials by the above-described procedure also when the collection tool is collected, it takes a lot of effort and time.

Further, since the plate glass can be used as a raw material of high-purity recycled glass, it is desirable that the plate glass can be separated and collected as it is.

An object of the present invention is to provide a solar cell module recycling system and a solar cell module recycling method capable of collecting a valuable material and collecting a collection tool efficiently by one processing to reuse the collection tool.

### Solution to Problem

A solar cell module recycling system of the present invention includes:
a thermal decomposition furnace configured to thermally decompose a used solar cell module mounted on a collection tool;
a module collection conveyor configured to collect a thermally decomposed solar cell module thermally decomposed in the thermal decomposition furnace together with the collection tool;
a glass collection conveyor configured to collect plate glass included in the thermally decomposed solar cell module transferred to the module collection conveyor;
a valuable material collection unit configured to collect valuable materials other than the plate glass, the valuable materials being included in the thermally decomposed solar cell module; and
a tool collection unit configured to collect the collection tool remaining on the module collection conveyor after the plate glass and the valuable materials are collected.

As such, the module collection conveyor collects the thermally decomposed solar cell module together with the collection tool, further separates and collects the plate glass and the valuable materials other than the plate glass, and then the tool collection unit collects the collection tool remaining on the module collection conveyor, so that the glass and the other valuable materials can be collected and the collection tool can be collected efficiently by one processing to reuse the collection tool.

Further, according to the solar cell module recycling system of the present invention,
the module collection conveyor rotates with the collection tool fixed to a conveyor belt after the thermally decomposed solar cell module is collected together with the collection tool until the collection tool is collected by the tool collection unit.

As such, since the collection tool rotates while being fixed to the conveyor belt until the collection tool is collected, when the collection tool is collected, the collection tool can be picked up at the same position as when the collection tool is transferred to the conveyor belt, and the collection tool can be efficiently collected.

Further, according to the solar cell module recycling system of the present invention,
the module collection conveyor includes fixing belts fixedly disposed in parallel at end portions on both outer peripheral sides of the module collection conveyor except for an upper surface of the module collection conveyor.

As a result, the collection tool can be moved while being sandwiched between the conveyor belt and the fixing belts, and the collection tool can be prevented from falling off from the conveyor belt even when the conveyor belt rotates and the collection tool is positioned at the lower portion of the module collection conveyor. In addition, since the upper portions of the fixing belts are open, it is possible to easily pick up the collection tool when the plate glass and the other valuable materials are separated and collected and one rotation of the collection tool is completed.

Further, according to the solar cell module recycling system of the present invention,
the valuable materials other than the plate glass include cells and a ribbon wire connecting the cells to each other.

That is, it is an object of the present invention to effectively recycle the plate glass as a material of recycled glass, and to effectively recycle the cells and the ribbon wire as other valuable materials.

Further, according to the solar cell module recycling system of the present invention,
the valuable materials other than the plate glass further include granular glass.

That is, the discarded solar cell module also includes solar cell modules in which the plate glass (tempered glass) is cracked from beginning, and here, the plate glass is crushed into granular glass having about 1 cm. Then, it is also an object of the present invention to effectively recycle the granular glass together with the cells and the ribbon wire.

A solar cell module recycling method of the present invention includes:
a thermal decomposition step of thermally decomposing a used solar cell module mounted on a collection tool by a thermal decomposition furnace;
a module collection step of transferring the thermally decomposed solar cell module thermally decomposed in the thermal decomposition furnace to a module collection conveyor together with the collection tool and collecting the thermally decomposed solar cell module together with the collection tool;
a glass collection step of collecting plate glass included in the thermally decomposed solar cell module transferred to the module collection conveyor;
a valuable material collection step of collecting valuable materials other than the plate glass, the valuable materials being included in the thermally decomposed solar cell module; and
a tool collection step of collecting the collection tool remaining on the module collection conveyor after the plate glass and the valuable materials are collected.

As such, the module collection conveyor collects the thermally decomposed solar cell module together with the collection tool, further separates and collects the plate glass and the valuable materials other than the plate glass, and then the tool collection unit collects the collection tool remaining on the module collection conveyor, so that the glass and the other valuable materials can be collected and the collection tool can be collected efficiently by one processing to reuse the collection tool.

Further, according to the solar cell module recycling method of the present invention,
in the module collection step, the collection tool rotates while being fixed to a conveyor belt.

As such, since the collection tool rotates while being fixed to the conveyor belt until the collection tool is collected, when the collection tool is collected, the collection tool can be picked up at the same position as when the collection tool is transferred to the conveyor belt, and the collection tool can be efficiently collected.

Further, according to the solar cell module recycling method of the present invention,
the valuable materials other than the plate glass include cells and a ribbon wire connecting the cells to each other.

That is, it is an object of the present invention to effectively recycle the plate glass as a material of recycled glass, and to effectively recycle the cells and the ribbon wire as other valuable materials.

Further, according to the solar cell module recycling method of the present invention,
the valuable materials other than the plate glass further include granular glass.

That is, the discarded solar cell module also includes solar cell modules in which the plate glass (tempered glass) is cracked from beginning, and here, the plate glass is crushed into granular glass having about 1 cm. Then, it is also an object of the present invention to effectively recycle the granular glass together with the cells and the ribbon wire.

### Advantageous Effects of Invention

According to the present invention, it is possible to provide a solar cell module recycling system and a solar cell module recycling method capable of collecting valuable materials and collecting a collection tool efficiently by one processing to reuse the collection tool.

### Brief Description of Drawings

Fig. 1 is a schematic view illustrating a solar cell module according to an embodiment.
Fig. 2 is a schematic view illustrating a solar cell module recycling system according to the embodiment.
Fig. 3 is a schematic view illustrating a layer structure of the solar cell module placed on a base according to the embodiment.
Fig. 4 is a schematic view illustrating a flow of a solar cell module recycling method according to the embodiment.
Fig. 5 is a schematic view illustrating a structure of a collection net (collection tool) according to the embodiment.
Fig. 6 is a schematic view illustrating a process in which the solar cell module according to the embodiment is decomposed in a thermal decomposition furnace.
Fig. 7 is a schematic view illustrating a module collection conveyor according to the embodiment.
Fig. 8 is a schematic view illustrating the collection net fixed to the module collection conveyor according to the embodiment.
Fig. 9 is a schematic view illustrating a situation in which plate glass, cells, a ribbon wire, and the collection net placed on the module collection conveyor according to the embodiment are separated.
Fig. 10 is a schematic view illustrating a cleaning device that cleans the plate glass collected by a glass collection conveyor according to the embodiment.
Fig. 11 is a schematic view illustrating a collection net fixed to a module collection conveyor according to another embodiment.

### Description of Embodiments

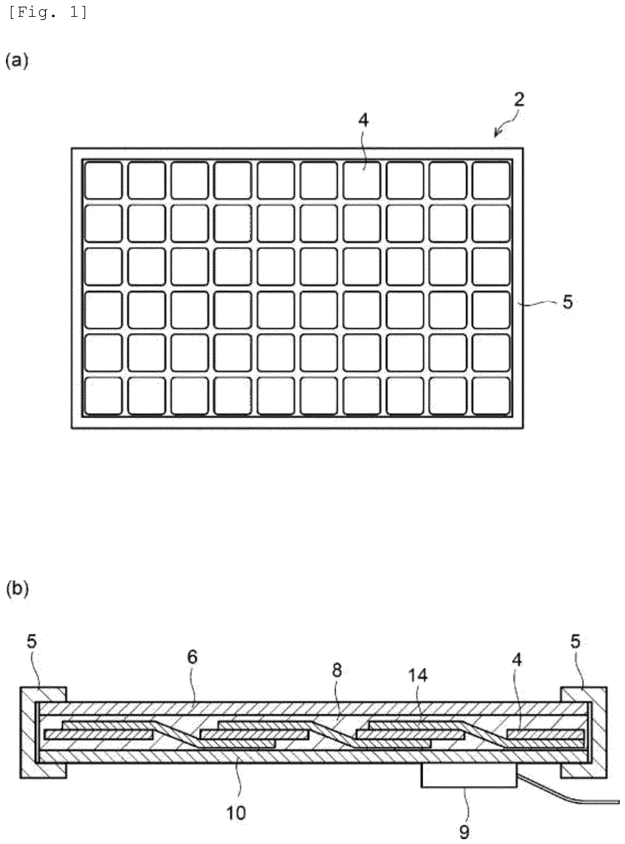

Hereinafter, a solar cell module recycling system (hereinafter, abbreviated as a recycling system) according to an embodiment of the present invention will be described with reference to the drawings. Fig. 1(a) is a schematic view illustrating the solar cell module according to the embodiment as viewed from above, and Fig. 1(b) is a schematic view illustrating the cross section thereof.

As illustrated in Fig. 1(a), a solar cell module 2 has a rectangular shape, cells (solar cell elements) 4 are disposed in a matrix configuration in the solar cell module 2, and a frame 5 is disposed as an outer frame of the solar cell module 2. An aluminum frame is mainly used for the frame 5. Further, as illustrated in Fig. 1(b), the solar cell module 2 is formed by stacking three layers including a plate glass 6, a sealing resin layer 8, and a back sheet 10 from the upper side, and is provided with a terminal box 9 attached to a lower portion thereof and configured to supply power generated by the cells 4 to a storage battery (not illustrated), for example. Note that EVA is generally used as a sealing resin, and polyethylene terephthalate (PET) is generally used for the back sheet 10.

In the sealing resin layer 8, the cells 4 and a ribbon wire 14 connecting the cells 4 to each other are sealed, and in the sealing resin layer 8, the sealing resin, the cells 4, and the ribbon wire 14 are integrally and firmly bonded. Therefore, it is extremely difficult to decompose the solar cell module 2 as it is and separate the plate glass 6 (tempered glass), the cells 4, and the ribbon wire 14.

Note that any solar cell module can be used as the solar cell module 2 that can be applied to the present invention as long as the solar cell module is not a double-sided glass type and has a resin back sheet. Specific examples thereof include monocrystalline silicon solar cells, polycrystalline silicon solar cells, amorphous silicon solar cells, heterojunction solar cells, CIS solar cells, CIGS solar cells, and CdTe solar cells.

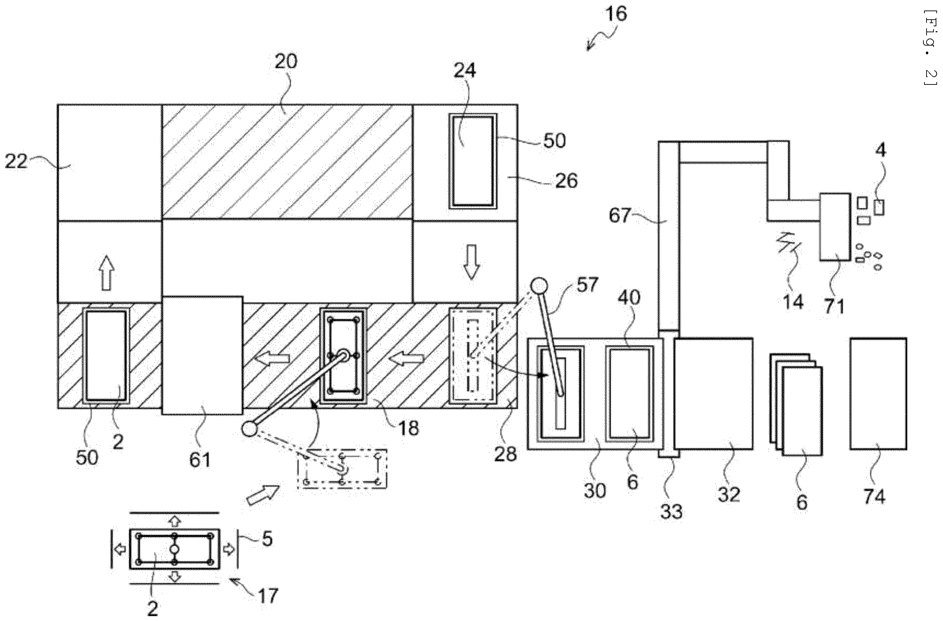

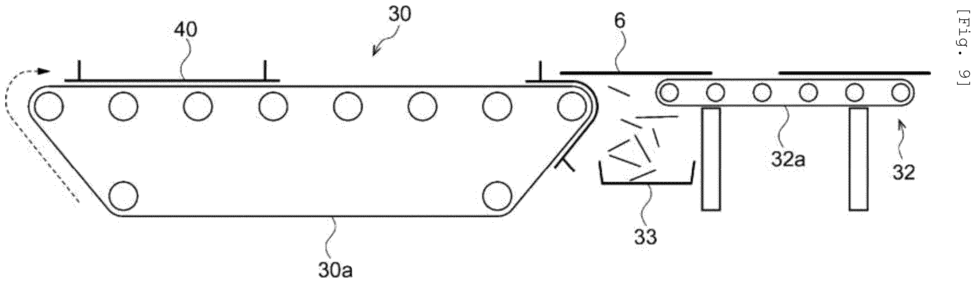

Fig. 2 is a schematic view illustrating a recycling system 16 according to the embodiment. As illustrated in Fig. 2, the recycling system 16 includes a removal zone 17 for removing the frame 5 and the terminal box 9, a mounting zone 18 for mounting the solar cell module 2, a thermal decomposition furnace 20, a standby zone 22 for introducing the solar cell module 2 into the thermal decomposition furnace 20, a discharge zone 26 from which a thermally decomposed solar cell module 24 thermally decomposed in the thermal decomposition furnace 20 is discharged, a collection zone 28 for collecting a collection net 40 to be described later, a module collection conveyor 30, a glass collection conveyor 32 for collecting the plate glass 6 by a roller conveyor 32a (refer to Fig. 9), a valuable material collection unit 33 for collecting valuable materials other than the plate glass **6,** a sorter 71 for sorting the valuable materials other than the plate glass 6 into the cells 4 and the ribbon wire 14, and a cleaning device 74 for cleaning the collected plate glass 6.

Next, a solar cell module recycling method according to an embodiment of the present invention will be described with reference to the drawings.

First, the used solar cell module 2 carried into a factory is transferred to the removal zone 17, and the frame 5 and the terminal box 9 are removed by a frame removal device (not illustrated). Note that, when the frame 5 is removed before thermal decomposition, there is an advantage in that it is not necessary to cut a first filter 42 to be described later according to the size of the frame 5 and operation becomes simple, but the frame 5 may be removed after thermal decomposition to reduce a possibility that the plate glass 6 is broken during removal of the frame 5.

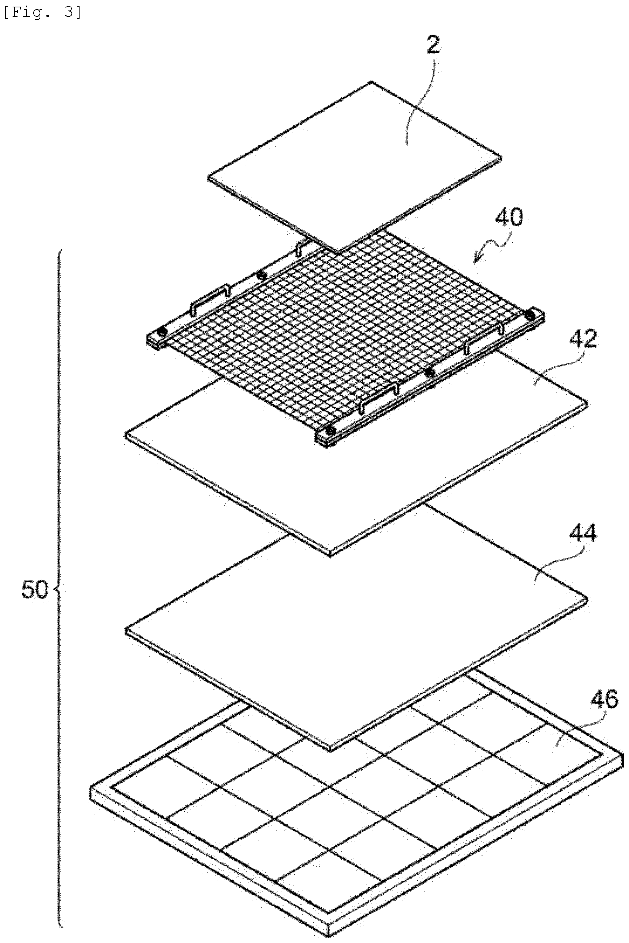

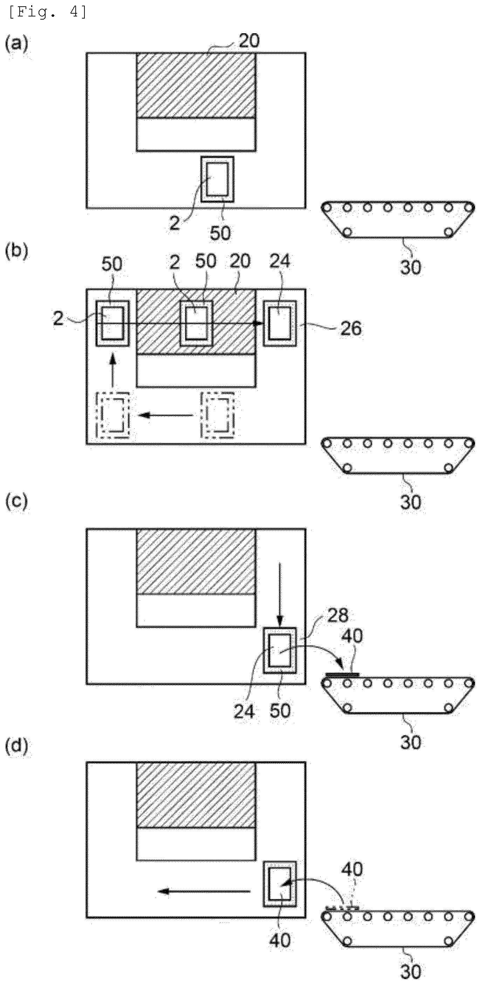

Next, the solar cell module 2 is mounted in the mounting zone 18. Here, in the mounting zone 18, as illustrated in Fig. 3, a substrate 50 formed by stacking the collection net 40 (collection tool), the first filter 42, a second filter 44, and a tray 46 in this order from the upper side is on standby in advance, and the solar cell module 2 is placed on the collection net 40 located at the uppermost layer of the substrate 50 (refer to Figs. 2 and 4(a)).

Here, a porous molded body having heat resistance is mainly used for the first filter 42. Specific examples of a material thereof include stable and common ceramic materials such as alumina, zirconia, silicon nitride, silicon carbide, cordierite, ferrite, barium titanate, lead zirconate titanate, forsterite, zircon, mullite, steatite, and aluminum nitride.

Further, as the second filter 44, a filter in which a catalyst such as titanium oxide or iron oxide is attached to the first filter 42 is used.

The tray 46 is a member located at the lowermost layer of the substrate 50 and formed to surround a central net-like portion with an outer frame, and is mainly made of iron.

Note that a member such as a grid for securing a gap for accelerating thermal decomposition may be disposed between the collection net 40 and the first filter 42.

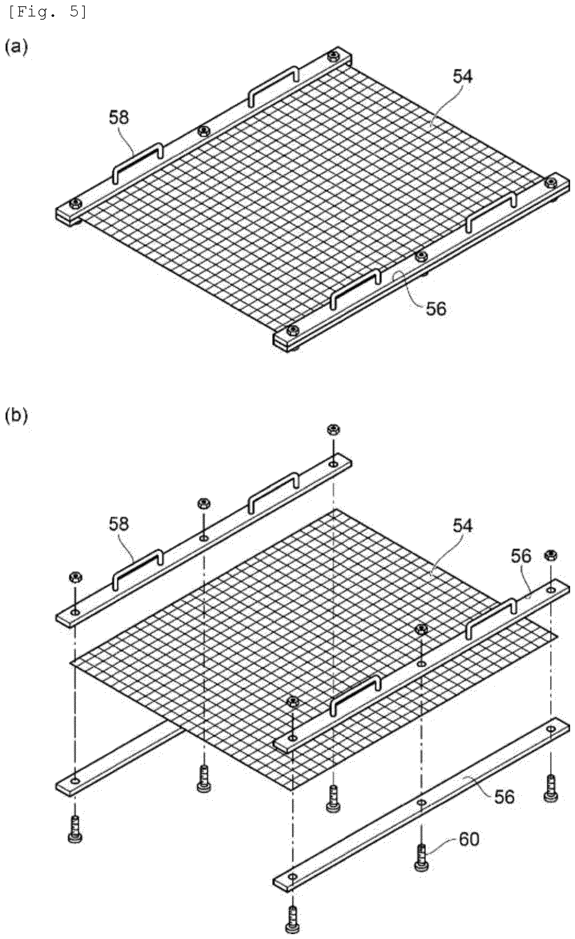

Fig. 5(a) is a view illustrating the collection net 40. The collection net 40 is formed so that long side edges of a rectangular wire mesh 54 are sandwiched by flat bars 56. Therefore, the collection net 40 has a property of bending in the short side direction but not bending in the long side direction.

On the upper surface of the flat bar 56, a suspended portion 58 for suspending the collection net 40 by a lift 57 (refer to Fig. 2) is formed.

As illustrated in Fig. 5(b), the flat bars 56 are positioned above and below the wire mesh 54, and clamp the wire mesh 54 by fixing the upper and lower flat bars 56 with a screw 60.

Furthermore, a flat bar having a structure for holding the entire end portion of the wire mesh 54, such as a flat bar having a C-shaped cross section sandwiching the end portion of the wire mesh 54, may be added between the upper and lower flat bars 56. As a result, when the wire mesh 54 is loaded, a load concentrated on the screw 60 can be dispersed, thereby making it possible to improve durability of the wire mesh 54.

The solar cell module 2 placed on the substrate 50 in the mounting zone 18 is kept warm in a heat insulating tank 61, transferred to the standby zone 22 (refer to Fig. 2), and then introduced into the thermal decomposition furnace 20, as illustrated in Fig. 4(b). The solar cell module 2 introduced into the thermal decomposition furnace 20 is thermally decomposed while being mounted on the collection net 40 (thermal decomposition step).

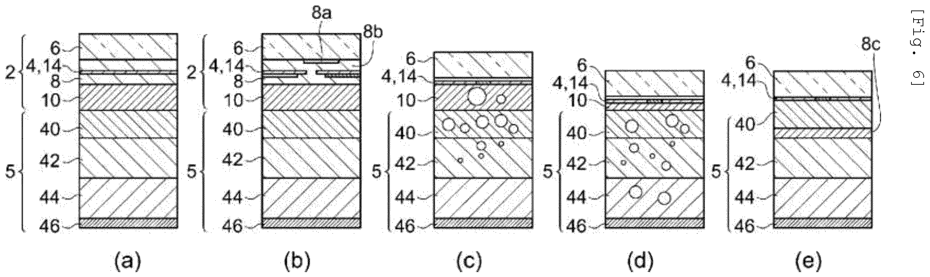

Fig. 6 is a view illustrating a process in which the solar cell module 2 introduced into the thermal decomposition furnace 20 is thermally decomposed. That is, when the solar cell module 2 is introduced into the thermal decomposition furnace 20, in a layer structure in a state initially illustrated in Fig. 6(a), the sealing resin of the sealing resin layer 8 is thermally decomposed and an acetic acid gas 8a and a polyethylene (PE) 8b are discharged from the sealing resin as illustrated in Fig. 6(b).

Next, the sealing resin is melted as illustrated in Fig. 6(c), and subsequently, the back sheet 10 is melted as illustrated in Fig. 6(d). When the thermal decomposition is completed only the collection net 40, the plate glass 6, the cells 4, and the ribbon wire 14 are left on the first filter 42 in addition to a white pigment 8c mixed in the sealing resin as illustrated in Fig. 6(e). Note that, in the thermal decomposition furnace 20, three solar cell modules 2 can be thermally decomposed at once.

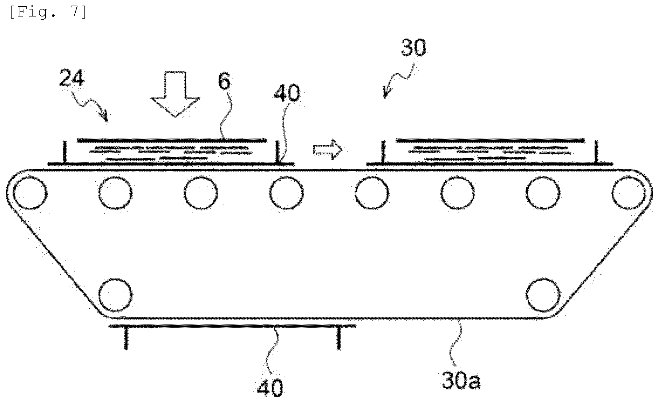

Next, the thermally decomposed solar cell module 24 is discharged to the discharge zone 26 as illustrated in Fig. 4(b), and then transferred to the collection zone 28 as illustrated in Fig. 4(c). Then, the collection net 40 is suspended by engaging a hook (not illustrated) of the lift 57 with the suspended portion 58 to be detached from the substrate 50 while the thermally decomposed solar cell module 24 is placed on the collection net 40, and the thermally decomposed solar cell module 24 is transferred (collected) together with the collection net 40 to the module collection conveyor 30 as illustrated in Fig. 7 (module collection step). In the collection zone 28, the substrate 50 including the first filter 42 and components disposed under the first filter 42 stands by as it is without the collection net 40 (refer to Fig. 4(c)).

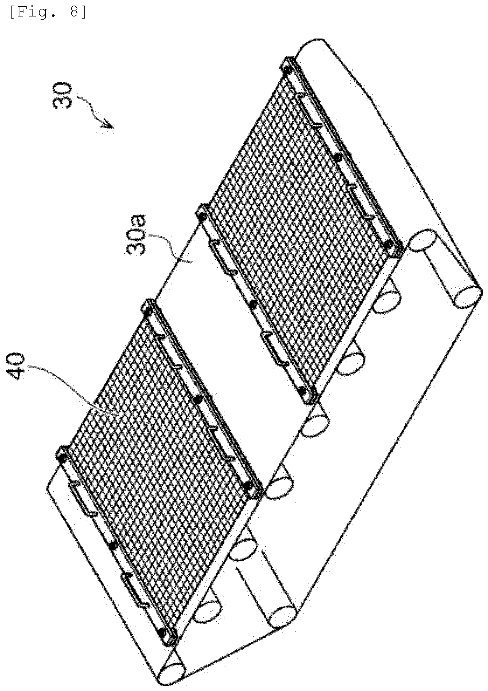

When the collection net 40 is transferred to the module collection conveyor 30 (refer to Fig. 8), four corners of the collection net 40 are fixed to a conveyor belt 30a by a fixing portion (not illustrated) (fixing step). As a result, when the conveyor belt 30a rotates and the collection net 40 is positioned at the lower portion of the module collection conveyor 30, it is possible to prevent the collection net 40 from falling off from the conveyor belt 30a.

The thermally decomposed solar cell module 24 transferred to the module collection conveyor 30 is naturally cooled on the conveyor belt 30a, then slid onto the glass collection conveyor 32 as it is as illustrated in Fig. 9, and then collected (glass collection step, refer to Fig. 2).

On the other hand, the collection net 40 continues to rotate as it is while being fixed to the conveyor belt 30a. Further, the cells 4 and the ribbon wire 14 included in the thermally decomposed solar cell module 24 fall from the conveyor belt 30a and are collected by the valuable material collection unit 33 (valuable material collection step). The cells 4 and the ribbon wire 14 collected by the valuable material collection unit 33 are conveyed to the sorter 71 by a valuable material conveyor 67, sorted into the cells 4 and the ribbon wire 14, and recycled as valuable materials.

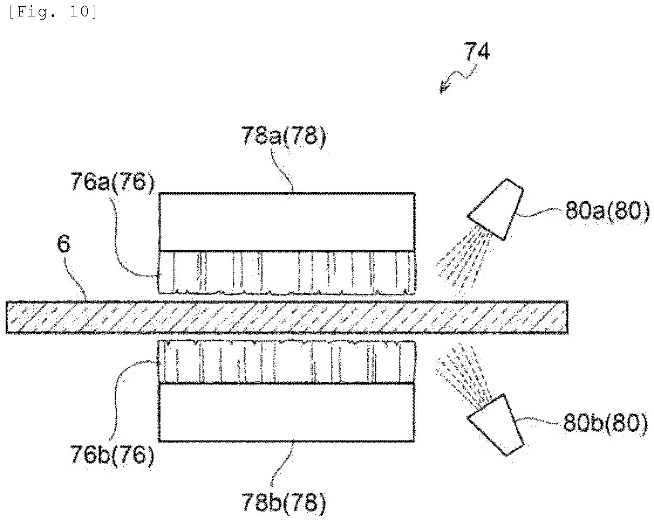

Fig. 10 is a schematic view illustrating the cleaning device 74 that cleans the plate glass 6 collected by the glass collection conveyor 32. As illustrated in Fig. 10, the cleaning device 74 includes an upper brush support 78a that supports an upper brush 76a and a lower structure 78b that supports a lower brush 76b. In addition, an upper suction device 80a and a lower suction device 80b that suction residues of the plate glass 6 brushed by the brush 76 are provided, respectively.

In the glass collection step, the plate glass 6 collected by the glass collection conveyor 32 is conveyed to the cleaning device 74 for further cleaning, and both front and back surfaces thereof are brushed. The plate glass 6 collected by the glass collection conveyor 32 may have resin residues attached thereto when bonding the cells 4, the ribbon wire 14, and the frame 5, and the residues are removed from the plate glass 6 by brushing the plate glass 6 with the brush 76.

After brushing, the residues are further suctioned from upper and lower suction devices 80, and the residues attached to the plate glass 6 are suctioned.

As a result, the plate glass 6 collected by the glass collection conveyor 32 is recycled as a material of a new plate glass after the attached substances such as organic substances and metals are removed therefrom (cleaning step).

Note that the discarded solar cell module 2 also includes solar cell modules in which the plate glass 6 is cracked from beginning, and the plate glass 6 is crushed into particles of about 1 cm as the plate glass 6 is tempered glass. When the crushed glass is treated by thermal decomposition, the form of the plate glass 6 is not collected, but the crushed glass is collected as granular glass together with the cells 4 and the ribbon wire 14 by the valuable material collection unit 33, and is sorted into crushed glass, the cells 4, and the ribbon wire 14 by the sorter 71 to be recycled as valuable materials or waste glass.

On the other hand, when the collection net 40 fixed to the conveyor belt 30a of the module collection conveyor 30 returns to the original position, the collection net is suspended by engaging the hook of the lift 57 (tool collection unit) with the suspended portion 58 again, and is returned onto the substrate 50 waiting in the collection zone 28 as illustrated in Fig. 4(d) (tool collection step).

After the collection net 40 is returned onto the substrate 50, the substrate 50 is transferred again to the mounting zone 18, and then a new solar cell module 2 is mounted thereon.

According to the invention of the present embodiment, it is possible to provide a solar cell module recycling system and a solar cell module recycling method capable of collecting glass and other valuable materials and collecting a collection tool efficiently by one processing to reuse the collection tool.

Specifically, the module collection conveyor 30 collects the thermally decomposed solar cell module 24 together with the collection net 40, further separates and collects the plate glass 6 and the valuable materials other than the plate glass 6, and then the lift 57 collects the collection net 40 remaining on the module collection conveyor 30 again, so that the glass and the other valuable materials can be collected and the collection net 40 can be collected efficiently by one processing to reuse the collection tool.

In addition, since the collection net 40 rotates while being fixed to the conveyor belt 30a until the collection net 40 is collected, when the collection net 40 is collected, the collection net 40 can be picked up at the same position as when the collection net 40 is transferred to the conveyor belt 30a, and the collection net 40 can be efficiently collected.

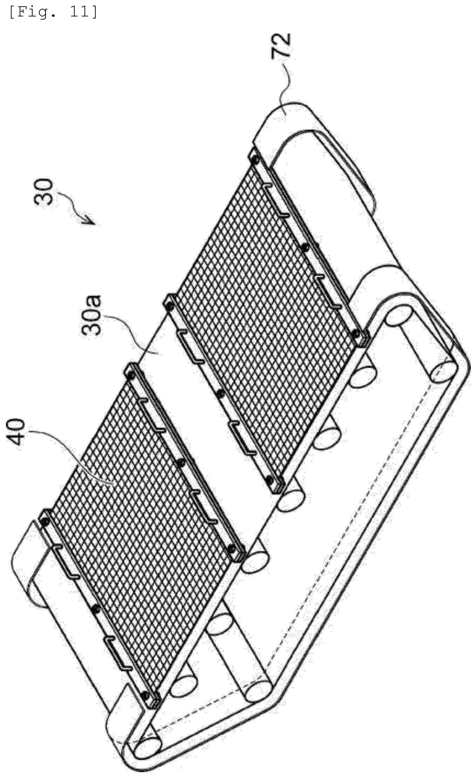

In the above-described embodiment, the collection net 40 is fixed by the fixing portion not to be detached from the conveyor belt 30a of the module collection conveyor 30, but two fixing belts 72 may be disposed in parallel at end portions on both outer peripheral sides of the module collection conveyor 30 except for the upper surface of the module collection conveyor 30 as illustrated in Fig. 11. Note that the fixing belts 72 do not rotate together with the conveyor belt 30a, and a metal plate is preferably used as a material of the fixing belts.

Here, the collection net 40 moves while both end portions orthogonal to a traveling direction are sandwiched between the conveyor belt 30a and the fixing belt 72 at the lower portion and the side of the module collection conveyor 30. Accordingly, it is possible to prevent the collection net 40 from falling off from the conveyor belt 30a when the conveyor belt 30a rotates and the collection net 40 is positioned at the lower portion of the module collection conveyor 30.

Note that, since the upper portion of the fixing belt 72 is open, it is possible to easily pick up the collection net 40 when the plate glass 6 and other valuable materials are separated and collected and one rotation of the collection net 40 is completed.

In addition, the collection net 40 can also be rotated together with the conveyor belt 30a using a frictional force between the collection net 40 and the conveyor belt 30a, but may be rotated while being fixed to the conveyor belt 30a in combination with a fixing portion.

In addition, in the above-described embodiment, a case in which the collection net 40 is used as the collection tool for collecting the solar cell module 2 is exemplified, but the collection tool is not necessarily the tool illustrated in the above-described embodiment. That is, any tool may be used as long as the tool has heat resistance capable of withstanding heating from the thermal decomposition furnace 20, has a structure that allows molten resin to pass through, has load resistance that withstands loads of the cells 4, the ribbon wire 14, and the plate glass 6 after heating processing, and can be fixed to the conveyor belt 30a and rotated without the cells 4 and the ribbon wire 14 falling from a gap. Specific examples that satisfy such conditions include punching metal having a thin plate and a tool obtained by connecting lattices to each other.

Further, in the above-described embodiment, the lift 57 is used again as the tool collection unit that collects the collection net 40 from the module collection conveyor 30, but the tool collection unit is not limited to a lift-shaped object as long as the tool collection unit has a function of placing the collection net 40 on the module collection conveyor 30 and collecting the collection net 40 on the module collection conveyor 30.

### Reference Signs List

- 2: Solar cell module
- 4: Cell
- 5: Frame
- 6: Plate glass
- 8: Sealing resin layer
- 8a: Acetic acid gas
- 8c: White pigment
- 9: Terminal box
- 10: Back sheet
- 14: Ribbon wire
- 16: Recycling system
- 17: Removal zone
- 18: Mounting zone
- 20: Thermal decomposition furnace
- 22: Standby zone
- 24: Thermally decomposed solar cell module
- 26: Discharge zone
- 28: Collection zone
- 30: Module collection conveyor
- 30a: Conveyor belt
- 32: Glass collection conveyor
- 32a: Roller conveyor
- 33: Valuable material collection unit
- 40: Collection net
- 42: First filter
- 44: Second filter
- 46: Tray
- 50: Substrate
- 54: Wire mesh
- 56: Flat bar
- 57: Lift
- 58: Suspended Portion
- 60: Screw
- 61: Heat insulating tank
- 67: Valuable material conveyor
- 71: Sorter
- 72: Fixing belt
- 74: Cleaning device
- 76: Brush
- 76a: Upper brush
- 76b: Lower brush
- 78a: Upper brush support
- 78b: Lower structure
- 80: Suction device
- 80a: Upper suction device
- 80b: Lower suction device

## Claims

1. A solar cell module recycling system comprising:
a thermal decomposition furnace configured to thermally decompose a used solar cell module mounted on a collection tool;
a module collection conveyor configured to collect a thermally decomposed solar cell module thermally decomposed in the thermal decomposition furnace together with the collection tool;
a glass collection conveyor configured to collect plate glass included in the thermally decomposed solar cell module transferred to the module collection conveyor;
a valuable material collection unit configured to collect valuable materials other than the plate glass, the valuable materials being included in the thermally decomposed solar cell module; and
a tool collection unit configured to collect the collection tool remaining on the module collection conveyor after the plate glass and the valuable materials are collected.

2. The solar cell module recycling system according to claim 1, wherein the module collection conveyor rotates with the collection tool fixed to a conveyor belt after the thermally decomposed solar cell module is collected together with the collection tool until the collection tool is collected by the tool collection unit.

3. The solar cell module recycling system according to claim **2,** wherein the module collection conveyor includes fixing belts fixedly disposed in parallel on both outer peripheral sides of the module collection conveyor except for an upper surface of the module collection conveyor.

4. The solar cell module recycling system according to any one of claims 1 to 3, wherein the valuable materials other than the plate glass include cells and a ribbon wire connecting the cells to each other.

5. The solar cell module recycling system according to claim 4, wherein the valuable materials other than the plate glass further include granular glass.

6. A solar cell module recycling method comprising:
a thermal decomposition step of thermally decomposing a used solar cell module mounted on a collection tool by a thermal decomposition furnace;
a module collection step of transferring the thermally decomposed solar cell module thermally decomposed in the thermal decomposition furnace to a module collection conveyor together with the collection tool and collecting the thermally decomposed solar cell module together with the collection tool;
a glass collection step of collecting plate glass included in the thermally decomposed solar cell module transferred to the module collection conveyor;
a valuable material collection step of collecting valuable materials other than the plate glass, the valuable materials being included in the thermally decomposed solar cell module; and
a tool collection step of collecting the collection tool remaining on the module collection conveyor after the plate glass and the valuable materials are collected.

7. The solar cell module recycling method according to claim **6,** wherein, in the module collection step, the collection tool rotates while being fixed to a conveyor belt.

8. The solar cell module recycling method according to claim 6 or 7, wherein the valuable materials other than the plate glass include cells and a ribbon wire connecting the cells to each other.

9. The solar cell module recycling method according to claim 8, wherein the valuable materials other than the plate glass further include granular glass.
